(19) **Europäisches Patentamt / European Patent Office / Office européen des brevets**

(11) **EP 2 602 631 B1**

(12) # EUROPEAN PATENT SPECIFICATION

(45) Date of publication and mention
of the grant of the patent:
**12.06.2019 Bulletin 2019/24**

(51) Int Cl.:
*G01R 35/00* (2006.01)   *H01Q 3/26* (2006.01)
*H04B 7/185* (2006.01)   *G01R 29/10* (2006.01)

(21) Application number: **11814553.1**

(22) Date of filing: **22.07.2011**

(86) International application number:
**PCT/JP2011/067379**

(87) International publication number:
**WO 2012/017927 (09.02.2012 Gazette 2012/06)**

(54) **CALIBRATION DEVICE AND CALIBRATION METHOD FOR ARRAY ANTENNA**

KALIBRIERVORRICHTUNG UND KALIBRIERVERFAHREN FÜR ARRAY-ANTENNEN

DISPOSITIF D'ÉTALONNAGE ET PROCÉDÉ D'ÉTALONNAGE POUR ANTENNE RÉSEAU

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **02.08.2010 JP 2010173338**

(43) Date of publication of application:
**12.06.2013 Bulletin 2013/24**

(73) Proprietor: **NEC Corporation
Tokyo 108-8001 (JP)**

(72) Inventor: **KOISHI, Youichi
Tokyo 108-8001 (JP)**

(74) Representative: **Vossius & Partner
Patentanwälte Rechtsanwälte mbB
Siebertstrasse 3
81675 München (DE)**

(56) References cited:
**WO-A1-98/00930     JP-A- 8 256 008
JP-A- 10 335 921     JP-A- 2002 171 115
JP-A- 2005 062 040     JP-A- 2006 203 658
JP-A- 2006 270 847     JP-A- 2007 318 407
JP-A- 2010 041 577     KR-B1- 100 762 218**

**Description**

This invention relates to a calibration device and a calibration method for an array antenna which is mounted on a satellite or the like.

Directivity characteristics and side lobe characteristics of an array antenna are determined on the premise that respective array systems are sufficiently calibrated. Therefore, the directivity of the array antenna is determined based on weighting coefficients which are set independently for elements.

As a technology for such calibration of the array antenna, JP 2004-104751 A (Patent Literature 1) discloses a method of correcting distortion of patterns occurring due to coupling between antennas. An antenna apparatus which performs this calibration method includes a correction computing unit for calculating, based on a mutual impedance matrix between antennas including all of a weight computing circuit, AD/DA converters, up-converters and down-converters, RF circuit units, and antenna elements, and on a desired input signal matrix, an inverse matrix of the mutual impedance matrix, and setting a signal matrix, which is obtained by multiplying the desired input signal matrix by the inverse matrix, as input signals of the respective antennas. Accordingly, the antenna apparatus suppresses the fluctuation in antenna radiation patterns occurring due to the mutual coupling between the antennas, to thereby perform an accurate adaptive operation.

Further, JP 2004-260319 A (Patent Literature 2) discloses an array antenna apparatus capable of actively changing the antenna directivity determined by antennas of different types under a state in which the respective antennas are arranged so that electrical lengths become approximate to each other. This array antenna apparatus includes a matrix table storing a matrix, which is represented by parameters having no dependence on angles of arrival and indicates coupling between elements of the respective antennas, a directivity synthesizing unit for performing antenna directivity synthesis processing for the respective antennas, and a mutual coupling compensating unit for multiplying directivity-synthesized vector data, which is output from the directivity synthesizing unit, by an inverse matrix of the matrix stored in the matrix table, and outputting a multiplication result as weighting coefficients for the respective antennas. Accordingly, desired antenna directivity synthesis and incoming wave identification are performed without being affected by the mutual coupling between the antenna elements.

Further, JP 2008-216152 A (Patent Literature 3) discloses an event detecting apparatus for detecting an event, such as movement of a person and an opening and closing operation of a door, with high accuracy even when a narrow-band signal is used as a radio signal. This event detecting apparatus includes a plurality of antennas for receiving radio waves transmitted from a transmitter, correlation matrix computing means for computing a correlation matrix based on reception vectors which are obtained from signals received by the plurality of antennas, eigenvector computing means for computing an eigenvector which covers a signal subspace through eigenvalue decomposition of the correlation matrix computed by the correlation matrix computing means, and event detecting means for detecting an event by detecting a temporal change of the eigenvector computed by the eigenvector computing means. Accordingly, an event can be detected with high accuracy even when a narrow-band signal is used.

KR 100 762 218 B1 relates to an apparatus for calibrating transmitters and receivers in an array antenna system aimed at performing calibration for the distortion of an RF (Radio Frequency) transmitter and an RF receiver even when the system operates.

WO 98/00930 A1 relates to a signal processing method for enhancing the communication quality and increasing the communication capacity by reducing the effects of interference and noises.

However, in Patent Literatures 1 to 3 described above, there is a problem in that, when an amplifier, a cable, or the like mounted on a satellite or the like which is located along an orbit is thermally affected to cause a change in characteristics, the change in directivity characteristics and side lobe characteristics of the array antenna occurring due to the thermal effect or the like cannot be calibrated with the communication function being operated.

In view of the above, this invention provides a calibration device and a calibration method for an array antenna which are capable of performing calibration in parallel to a communication function.


Means to Solve the Problem


According to this invention, there is provided a calibration device to calibrate an array antenna arranged in space, the calibration device including: a calibration coefficient calculating unit to receive a plurality of input signals obtained by performing, in respective systems, predetermined signal processing for signals received by the array antenna, to calculate a correlation of the plurality of input signals, and to calculate weighting coefficients for calibrating the array antenna; and a calibration executing unit for calibrating the array antenna based on the weighting coefficients.

Further, there is provided a calibration method to calibrate an array antenna arranged in space, the calibration method including: a calibration coefficient calculating step of receiving a plurality of input signals obtained by performing, in respective systems, predetermined signal processing for signals received by the array antenna, calculating a correlation of the plurality of input signals, to calculating weighting coefficients for calibrating the respective systems of the array antenna; and a calibration executing step of calibrating the array antenna based on the weighting coefficients.

Effect of the Invention

According to this invention, the calibration can be performed with high accuracy while being adapted to the change in environmental condition, and thus the reliability is improved.

Brief Description of the Drawing

Fig. 1 is a schematic diagram illustrating a state in which an array antenna apparatus is mounted on a satellite and communicates to/from a ground station according to a first embodiment of this invention.
Fig. 2 is a block diagram of the array antenna apparatus and a calibration device according to the first embodiment.
Fig. 3 is a flow chart illustrating a calibration procedure for systems of respective antennas according to the first embodiment.
Fig. 4 is a schematic diagram illustrating a state in which an array antenna apparatus is mounted on a satellite and communicates to/from ground stations according to a second embodiment of this invention.
Fig. 5 is a block diagram of the array antenna apparatus and a calibration device according to the second embodiment.

Best Mode for Embodying the Invention

Embodiments of this invention are described.

<First Embodiment>

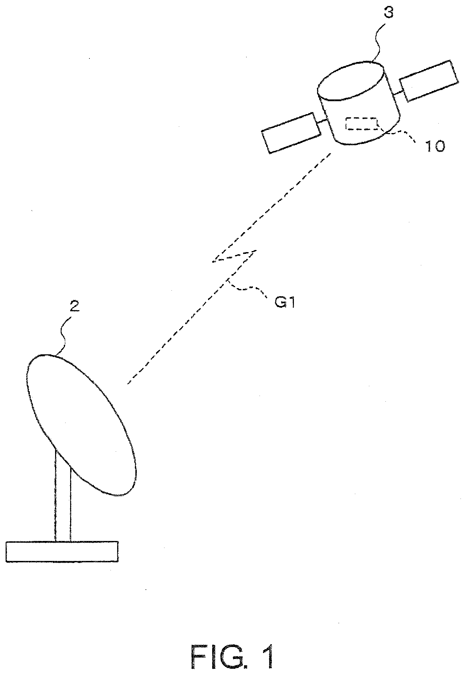

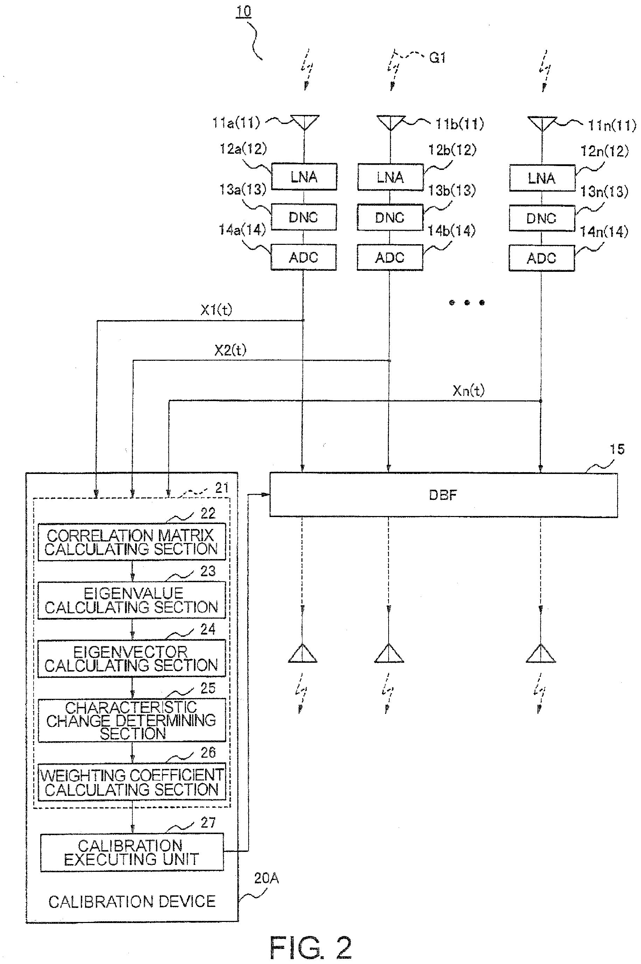

Fig. 1 is a schematic diagram illustrating a state of communications between, for example, a satellite 3 including an array antenna apparatus 10 mounted thereon and a ground station 2. Fig. 2 is a block diagram of the array antenna apparatus 10 including a calibration device 20A.

Calibration signals G1 are transmitted from the ground station 2 to the satellite 3. The satellite 3 receives the calibration signals G1 via an array antenna. Then, the calibration device 20A calculates weighting coefficients for calibrating the respective antennas based on the received calibration signals G1, and accordingly systems of the respective antennas are calibrated.

Note that, a beacon is taken as an example of the calibration signal G1, but this invention is not limited thereto.

The array antenna apparatus 10 as described above includes antennas 11 (11a to 11n), low noise amplifiers (LNAs) 12 (12a to 12n), down-converters (DNCs) 13 (13a to 13n), analog/digital conversion (ADC) units 14 (14a to 14n), a digital beam forming (DBF) unit 15, and the calibration device 20A. Further, a single system is formed of a single antenna 11, a single LNA 12, a single DNC 13, and a single ADC 14. Fig. 2 illustrates a case where n systems are formed.

The calibration signal G1 received by each antenna 11 is amplified by the LNA 12, and is subjected to frequency conversion by the DNC 13 into a low-frequency signal. After that, the low-frequency signal is converted to a digital signal by the ADC 14. In the following description, the resultant digital signal is referred to as "input signal $Xi(t,P)$" assuming that a reception time point is "t". In this case, the suffix "i" represents a signal input to an i-th system. Further, the symbol "P" represents, as described later, a parameter indicating a change in characteristics of the system occurring due to disturbance factors such as a change in temperature of the system and entrance of radiations. Specifically, when P=0, there is no external factor.

The calibration device 20A includes a calibration coefficient calculating unit 21 for calculating the weighting coefficients, and a calibration executing unit 27 for calibrating the systems of the respective array antennas 11 based on the weighting coefficients. The calibration coefficient calculating unit 21 includes a correlation matrix calculating section 22, an eigenvalue calculating section 23, an eigenvector calculating section 24, a characteristic change determining section 25, and a weighting coefficient calculating section 26. Note that, as illustrated in Fig. 2, the input signal $Xi(t,P)$ is input to the calibration device 20A and to the DBF 15. Thus, the calibration device 20A operates in parallel to the operation of the communication part of the array antenna apparatus 10.

As defined above, the input signal $Xi(t,P)$ is a signal input to an i-th system at a time point "t". In a strict sense, the input signal $Xi(t,P)$ is a signal which is obtained by performing signal processing for the calibration signal G1 received by the antenna 11 and is in a state immediately before the signal is input to the DBF 15. A plurality of electronic instruments such as the LNA 12, the DNC 13, and the ADC 14 are provided between the antenna 11 and the DBF 15, and those electronic instruments perform predetermined signal processing.

When the satellite 3 is a geostationary satellite, the intensity of light from the sun changes in accordance with the position of the satellite 3. As a result, for example, when the sun, the earth, and the satellite are aligned in this order (in a state of a solar eclipse as seen from the satellite, that is, a state in which the satellite is located behind the earth), the temperature of the satellite decreases. Conversely, when the sun, the satellite, and the earth are aligned in this order, the temperature of the satellite increases. Further, there are various kinds of radiations (for example, alpha rays and gamma rays) in the space, and those radiations may enter the electronic instruments.

The electronic instruments include a large number of electronic devices such as a semiconductor device, and hence device characteristics change due to the change in temperature and entrance of radiations. As a result, an input signal Xi(t,P≠0), which is different from an input signal Xi(LP=0) in a case where there is no change in temperature and exposure of radiations, is input to the DBF 15. Such a change in characteristics occurring due to the temperature and radiations is hereinafter referred to as "change in characteristics due to disturbance".

As described above, the change in characteristics due to disturbance occurs in the electronic devices and the like, which leads to a change in characteristics of the electronic instruments. In general, in a case of an electronic apparatus which is used on the ground, maintenance such as replacement of components and calibration can be performed. However, in a case of a satellite which is used in the space, such maintenance cannot be performed.

Therefore, this embodiment is aimed so that the calibration processing can be performed based on the input signal Xi(t,P) even when the change in characteristics due to disturbance occurs in the array antenna apparatus 10 mounted on the satellite. Note that, the calibration processing may be performed based on input signals Xi(t,P) which are input in real time. Further, the calibration processing may be performed based on a mean value of the input signals Xi(t,P) obtained within a given period of time so as to suppress effects of sudden noise and the like. The following description takes as an example a case of performing the calibration processing based on the input signals Xi(t,P) which are input in real time.

In this calibration, the calibration coefficient calculating unit 21 of the calibration device 20A calculates calibration parameters (weighting coefficients), and the calibration is performed based on the weighting coefficients.

The correlation matrix calculating section 22 of the calibration coefficient calculating unit 21 receives the input signals Xi(t,P) of the respective systems. At this time, a correlation matrix Rxx of the respective input signals Xi(t,P) is defined based on Expression (1):

$$
Rxx = \begin{vmatrix}
\langle X1(t)|X1(t)\rangle & \langle X1(t)|X2(t)\rangle & \cdots \langle X1(t)|Xn(t)\rangle \\
\langle X2(t)|X1(t)\rangle & \langle X2(t)|X2(t)\rangle & \cdots \langle X2(t)|Xn(t)\rangle \\
\\
\langle Xn(t)|X1(t)\rangle & \langle Xn(t)|X2(t)\rangle & \cdots \langle Xn(t)|Xn(t)\rangle
\end{vmatrix} \quad \cdots (1)
$$

where "<X1|" or the like represents a vector, and "|X1>" has a complex conjugate relationship with "<X1|".

Assuming that "λ" represents an eigenvalue of the correlation matrix Rxx and "W" represents an eigenvector of the correlation matrix Rxx, the matrix equation is expressed by Expression (2):

$$ RxxW = \lambda W \ ... \ (2) $$

Therefore, assuming that "I" represents an identity matrix, the characteristic equation is expressed by Expression (3):

$$ |Rxx - \lambda I| = 0 \ ... \ (3) $$

The eigenvalue calculating section 23 solves Expression (3) to determine the eigenvalues λ. There are a plurality of eigenvalues λ, and hence the maximum value thereof is represented by "λmax". Using the maximum eigenvalue λmax, Expression (2) is expressed by Expression (4):

$$ (Rxx - \lambda maxI)W = 0 \ ... \ (4) $$

The eigenvector calculating section 24 calculates the eigenvector W based on Expression (4).

Assuming that "Wc" represents an eigenvector before the change in characteristics due to disturbance and "W" represents an eigenvector after the change in characteristics, W≠Wc. Therefore, the characteristic change determining section 25 stores the eigenvector Wc, and determines whether or not the eigenvector Wc is equal to the eigenvector W calculated subsequently. In this manner, the calibration device 20A determines the necessity for the calibration processing. At this time, when the degree of agreement therebetween is not set, the calibration processing is executed even when there is substantially no change in characteristics. Therefore, the characteristic change determining section 25 stores a characteristic change determination reference T as a reference for determining the degree of agreement between the eigenvector W and the eigenvector Wc. Based on Expression (5), the characteristic change determining section 25 determines an inner product K of the eigenvector W and the eigenvector Wc, and when this value K is larger than the characteristic change determination reference T (K>T), the characteristic change determining section 25 determines that there is a change in characteristics due to disturbance.

$$K = <W|Wc> \ ... \ (5)$$

When the inner product K is larger than the characteristic change determination reference T (K>T), the characteristic change determining section 25 outputs the eigenvector W to the weighting coefficient calculating section 26.
The weighting coefficient calculating section 26 calculates weighting coefficients βW. At this time, "β" represents a proportionality constant, and for example, "β" is set so that the norm of the eigenvalue vector W becomes 1. The weighting coefficients βW calculated in this manner are output to the calibration executing unit 27. The calibration executing unit 27 uses the weighting coefficients to calibrate the systems of the respective antennas 11.
As described above, the calibration processing is performed in parallel to the communication processing, and hence, even when the communication processing is in progress, the calibration can be performed without interrupting the communication processing.

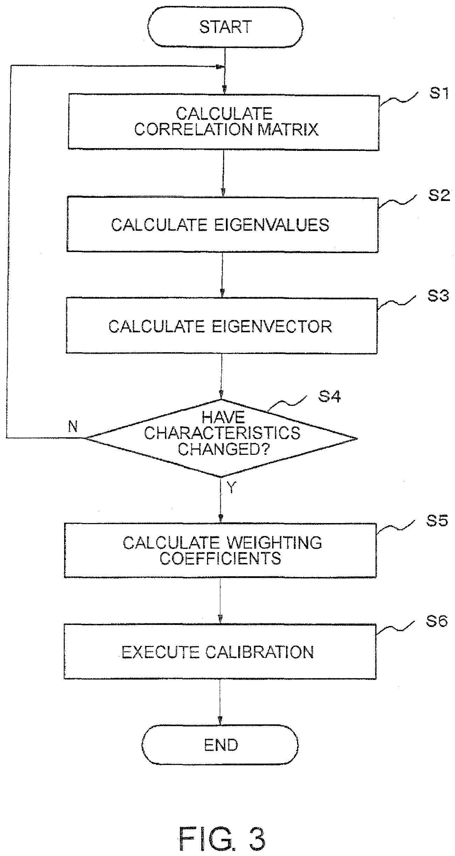

Fig. 3 is a flow chart illustrating a calibration procedure to be performed by the calibration device 20A for the systems of the respective antennas. As described above, the input signals received by the individual antennas 11 which form the array antenna are input to the DBF 15 via the LNAs 12, the DNCs 13, and the ADCs 14, and are input also to the calibration coefficient calculating unit 21 of the calibration device 20A. The correlation matrix calculating section 22 of the calibration coefficient calculating unit 21 calculates the correlation matrix Rxx based on the respective input signals Xi(t,P) affected by the change in temperature environment or the like (Step S1).
Then, the eigenvalue calculating section 23 calculates the eigenvalues of this correlation matrix Rxx, and outputs an eigenvalue having the maximum value as the maximum eigenvalue λmax (Step S2). The eigenvector calculating section 24 calculates the eigenvector W of the maximum eigenvalue λmax (Step S3).
Then, the characteristic change determining section 25 determines the inner product of the obtained eigenvector W and the stored eigenvector Wc, and determines whether or not the value of the inner product is larger than the characteristic change determination reference T (Step S4).
When the inner product is larger than the characteristic change determination reference T (when it is determined that the calibration processing is necessary because of the change in characteristics), the processing proceeds to Step S5, and when it is determined that the calibration is unnecessary, the processing returns to Step S1.
When it is determined that the calibration processing is necessary, the weighting coefficient calculating section 26 calculates the proportionality constant β so that the norm of the eigenvector W becomes 1, and calculates the weighting coefficients βW for calibrating the respective signals (Step S5). The calculated weighting coefficients βW are sent to the calibration executing unit 27, and accordingly the systems of the respective antennas 11 are calibrated (Step S6).
As described above, even when a change in characteristics peculiar to a special environment such as a space environment has occurred, the calibration processing can be performed automatically, and hence high-quality communications can be maintained.

<Second Embodiment>

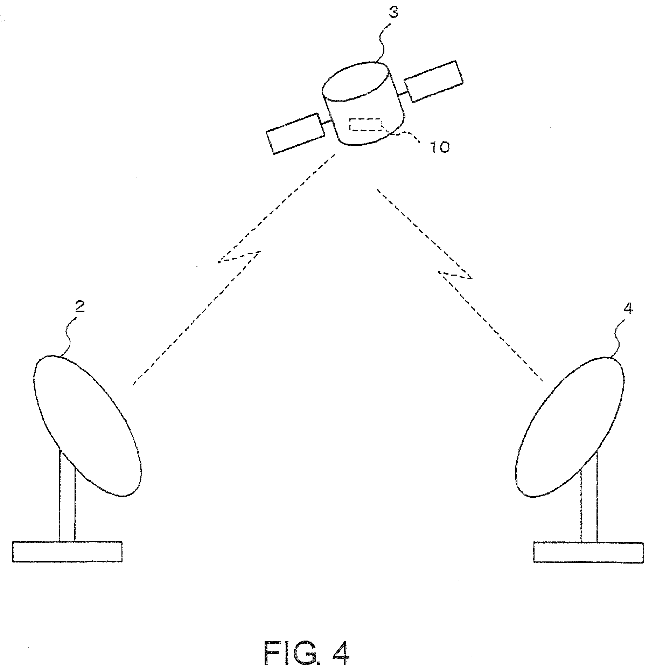

Next, a second embodiment of this invention is described. Note that, the same components as those in the first embodiment are represented by the same reference symbols, and description thereof is therefore omitted as appropriate. Fig. 4 is a schematic diagram illustrating a state in which the array antenna apparatus 10 is mounted on the satellite 3 or the like and communicates to/from ground stations 2 and 4.
At this time, the ground station 4 is a resource for calculating the weighting coefficients to be used for the calibration processing, and may have the same configuration as the ground station 2. Specifically, in the first embodiment, the calibration device 20A is mounted on the satellite 3 and the weighting coefficients are calculated for the calibration. However, the satellite 3 may have a risk in that sufficient computation resources cannot be stored therein. Therefore, in this embodiment, the satellite 3 communicates to/from the ground station 4 via a telemetry and command line. The satellite 3 temporarily transmits the input signals Xi(t,P) to the ground station 4, and the ground station 4 calculates the weighting coefficients.

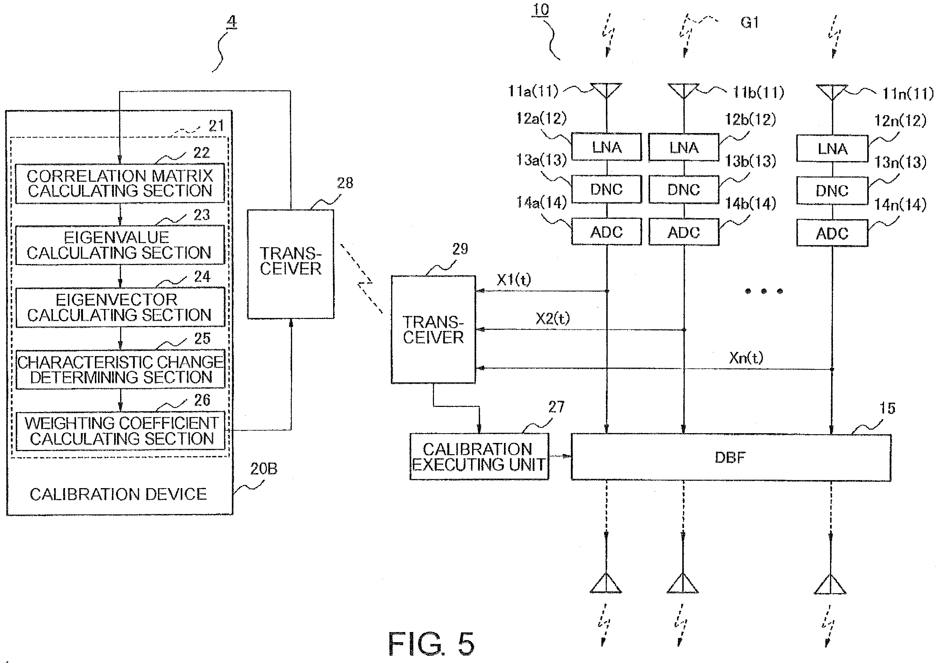

Fig. 5 is a block diagram of such an array antenna apparatus 10 and a calibration device 20B.

The calibration device 20B includes a transceiver 29 and the calibration executing unit 27, which are provided on the satellite 3 side, and a transceiver 28 and the calibration coefficient calculating unit 21, which are provided to the ground station 4.

When the transceiver 29 on the satellite 3 side has received the input signals Xi(t,P) from the respective antennas 11 which form the array antenna, the transceiver 29 transmits the input signals Xi(t,P) to the ground station 4. When the transceiver 28 of the ground station 4 has received the input signals Xi(t,P), the weighting coefficients βW are calculated in accordance with the above-mentioned procedure. The calculated weighting coefficients βW are transmitted from the transceiver 28, received by the transceiver 29, and sent to the calibration executing unit 27. The calibration executing unit 27 calibrates the systems of the respective antennas based on the received weighting coefficients βW.

Thus, even when sufficient computation resources for calculating the weighting coefficients are not stored in the satellite 3, even if the device characteristics have changed due to the effects of the change in temperature and the like, desired antenna patterns, side lobes, and the like can be obtained.

Note that, the specific configurations of this invention are not limited to the embodiments described above, and this invention encompasses modifications without departing from the gist of this invention. For example, the above-mentioned first to third embodiments may be combined as appropriate for operation.

This application claims priority from Japanese Patent Application No. 2010-173338, filed on August 2, 2010.

Reference Signs List

| | |
|---|---|
| 2, 4 | ground station |
| 3 | satellite |
| 10 | array antenna apparatus |
| 20A, 20B | calibration device |
| 21 | calibration coefficient calculating unit |
| 22 | correlation matrix calculating section |
| 23 | eigenvalue calculating section |
| 24 | eigenvector calculating section |
| 25 | characteristic conversion determining section |
| 26 | weighting coefficient calculating section |
| 27 | calibration executing unit |
| 28, 29 | transceiver |

**Claims**

1. A calibration device (20A, 20B) configured to perform calibration of a plurality of systems of an array antenna mounted on a satellite (3) together with a digital beam forming, DBF, unit (15), said satellite (3) being arranged in space, the calibration device (20A, 20B) being **characterized by**:

   a calibration coefficient calculating unit (21) configured to receive a plurality of input signals which are split by respective systems and which are input to the DBF unit (15) on the satellite (3), which are obtained by performing, in the respective systems, predetermined signal processing for signals received by the array antenna, to calculate a correlation of the plurality of the input signals, and to calculate weighting coefficients for the respective systems of the array antenna during satellite communication through the array antenna; and
   a calibration executing unit (27) configured to calibrate the respective systems of the array antenna by outputting the weighting coefficients to the DBF unit (15) so that calibration results of the respective systems are reflected to beam forming of the array antenna of the satellite (3).

2. The calibration device according to claim 1, wherein the calibration coefficient calculating unit (21) is configured to perform calibration based on a mean value of the plurality of the input signals obtained within a given period of time.

3. The calibration device (20A, 20B) according to claim 1 or 2, wherein the calibration coefficient calculating unit (21) comprises:

a correlation matrix calculating section (22) to calculate a correlation matrix of the plurality of input signals;
an eigenvalue calculating section (23) to calculate a maximum eigenvalue of the correlation matrix calculated by the correlation matrix calculating section (22);
an eigenvector calculating section (24) to calculate an eigenvector of the maximum eigenvalue; and
a weighting coefficient calculating section (26) to calculate a proportionality constant so that a norm of the eigenvector becomes 1, and output a product of the proportionality constant and the eigenvector as the weighting coefficients.

4. The calibration device (20A, 20B) according to any one of claims 1 to 3, further comprising a characteristic change determining section (25) configured to determine whether or not a change in characteristics has occurred in one or more electronic instruments provided inside the satellite (3) due to disturbance,
wherein the calibration device (20A, 20B) is configured to calculate the weighting coefficients only when the change in the characteristics has occurred inside the satellite (3), and is configured not to calculate the weighting coefficients when no change in the characteristics has occurred inside the satellite (3).

5. The calibration device (20A, 20B) according to any one of claims 1 to 4, wherein the calibration coefficient calculating unit (21) is mounted on a ground station (2,4), and is configured to receive the plurality of input signals from the satellite (3), calculate the weighting coefficients based on the plurality of input signals, and transmit the weighting coefficients to the satellite (3).

6. A calibration method for calibrating an array antenna of a plurality of systems mounted on a satellite (3) together with a digital beam forming, DBF, unit (15), the calibration method comprising:

a calibration coefficient calculating step of receiving a plurality of input signals which are split by the respective systems and which are input to the DBF unit (15) on the satellite (3), which are obtained by performing, in the respective systems, predetermined signal processing for signals received by the array antenna, to calculate a correlation of the plurality of input signals, and calculate weighting coefficients for the respective systems of the array antenna during satellite communication through the array antenna; and
a calibration executing step of calibrating each of the respective systems of the array antenna by outputting the weighting coefficients to the DBF unit (15) so that calibration results of the respective systems may be reflected to beam forming of the array antenna of the satellite (3).

7. The calibration method according to claim 6, wherein the calibration coefficient calculating step comprises:

receiving the plurality of the input signals and
performing calibration based on a mean value of the plurality of input signals obtained within a given period of time.

8. The calibration method according to claim 6 or 7, further comprising a characteristic change determining step of determining whether or not a change in characteristics has occurred in one or more electronic instruments provided inside the satellite (3) due to disturbance,
wherein the calibration coefficient calculating step comprises:
calculating the weighting coefficients only when change in characteristics has occurred inside the satellite, and not calculating the weighting coefficients when no change in characteristics has occurred inside the satellite (3).

9. The calibration method according to any one of claims 6 to 8, wherein the calibration coefficient calculating step comprises:

a correlation matrix calculating step of calculating a correlation matrix of the plurality of input signals;
an eigenvalue calculating step of calculating a maximum eigenvalue of the correlation matrix calculated in the correlation matrix calculating step;
an eigenvector calculating step of calculating an eigenvector of the maximum eigenvalue; and
a weighting coefficient calculating step of calculating a proportionality constant so that a norm of the eigenvector becomes 1, and outputting a product of the proportionality constant and the eigenvector as the weighting coefficients.

10. The calibration method according to any one of claims 7 to 9, wherein the calibration coefficient calculating step comprises the steps of:

transmitting the plurality of input signals to a ground station (2,4) from the satellite (3); and
transmitting the weighting coefficients calculated by the ground station (2,4) to the satellite (3) from the ground station (2,4).

**Patentansprüche**

1. Kalibriervorrichtung (20A, 20B), die dafür konfiguriert ist, eine Kalibrierung mehrerer Systeme einer Array-Antenne auszuführen, die zusammen mit einer digitalen Strahlformungs(DBF)einheit (15) auf einem Satelliten (3) montiert ist, wobei sich der Satellit (3) im Weltraum befindet, wobei die Kalibriervorrichtung (20A, 20B) **gekennzeichnet ist durch**:

eine Kalibrierungskoeffizientenberechnungseinheit (21), die dafür konfiguriert ist, mehrere Eingangssignale zu empfangen, die **durch** jeweilige Systeme geteilt und der DBF-Einheit (15) auf dem Satelliten (3) zugeführt werden, und die **durch** Ausführen einer vorgegebenen Signal verarbeitung in den jeweiligen Systemen für **durch** die Array-Antenne empfangene Signale erhalten werden, um eine Korrelation der mehreren Eingangssignale zu berechnen und um Gewichtungskoeffizienten für die jeweiligen Systeme der Array-Antenne während der Satellitenkommunikation über die Array-Antenne zu berechnen; und
eine Kalibrierungsausführungseinheit (27), die dafür konfiguriert ist, die jeweiligen Systeme der Array-Antenne **durch** Ausgeben der Gewichtungskoeffizienten an die DBF-Einheit (15) zu kalibrieren, so dass Kalibrierungsergebnisse der jeweiligen Systeme in die Strahlformung der Array-Antenne des Satelliten (3) einfließen.

2. Kalibriervorrichtung nach Anspruch 1, wobei die Kalibrierungskoeffizientenberechnungseinheit (21) dafür konfiguriert ist, eine Kalibrierung basierend auf einem Mittelwert der mehreren Eingangssignale auszuführen, die innerhalb einer vorgegebenen Zeitdauer erhalten werden.

3. Kalibriervorrichtung (20A, 20B) nach Anspruch 1 oder 2, wobei die Kalibrierungskoeffizientenberechnungseinheit (21) aufweist:

einen Korrelationsmatrixberechnungsabschnitt (22) zum Berechnen einer Korrelationsmatrix der mehreren Eingangssignale;
einen Eigenwertberechnungsabschnitt (23) zum Berechnen eines maximalen Eigenwerts der durch den Korrelationsmatrixberechnungsabschnitt (22) berechneten Korrelationsmatrix;
einen Eigenvektorberechnungsabschnitt (24) zum Berechnen eines Eigenvektors des maximalen Eigenwerts; und
einen Gewichtungskoeffizientenberechnungsabschnitt (26) zum Berechnen einer Proportionalitätskonstante derart, dass eine Norm des Eigenvektors den Wert 1 hat, und zum Ausgeben eines Produkts der Proportionalitätskonstante und des Eigenvektors als die Gewichtungskoeffizienten.

4. Kalibriervorrichtung (20A, 20B) nach einem der Ansprüche 1 bis 3, ferner mit einem Kenngrößenänderungsbestimmungsabschnitt (25), der dafür konfiguriert ist, zu bestimmen, ob in einem oder in mehreren elektronischen Instrumenten, die innerhalb des Satelliten (3) vorgesehen sind, aufgrund einer Störung eine Änderung von Kenngrößen aufgetreten ist oder nicht,
wobei die Kalibriervorrichtung (20A, 20B) dafür konfiguriert ist, die Gewichtungskoeffizienten nur dann zu berechnen, wenn innerhalb des Satelliten (3) eine Änderung der Kenngrößen aufgetreten ist, und dafür konfiguriert ist, die Gewichtungskoeffizienten nicht zu berechnen, wenn innerhalb des Satelliten (3) keine Änderung der Kenngrößen aufgetreten ist.

5. Kalibriervorrichtung (20A, 20B) nach einem der Ansprüche 1 bis 4, wobei die Kalibrierungskoeffizientenberechnungseinheit (21) in einer Bodenstation (2, 4) montiert und dafür konfiguriert ist, die mehreren Eingangssignale vom Satelliten (3) zu empfangen, die Gewichtungskoeffizienten basierend auf den mehreren Eingangssignalen zu berechnen und die Gewichtungskoeffizienten an den Satelliten (3) zu übertragen.

6. Kalibrierverfahren zum Kalibrieren einer Array-Antenne mehrerer Systeme, die zusammen mit einer digitalen Strahlformungs(DBF)einheit (15) auf einem Satelliten (3) montiert ist, wobei das Kalibrierverfahren aufweist:

einen Kalibrierungskoeffizientenberechnungsschritt zum Empfangen mehrerer Eingangssignale, die durch die jeweiligen Systeme geteilt und der DBF-Einheit (15) auf dem Satelliten (3) zugeführt und durch Ausführen einer vorgegebenen Signalverarbeitung in den jeweiligen Systemen für durch die Array-Antenne empfangene Signale erhalten werden, um eine Korrelation der mehreren Eingangssignale zu berechnen und Gewichtungskoeffizienten für die jeweiligen Systeme der Array-Antenne während einer Satellitenkommunikation über die Array-Antenne zu berechnen; und

einen Kalibrierungsausführungsschritt zum Kalibrieren jedes der jeweiligen Systeme der Array-Antenne durch Ausgeben der Gewichtungskoeffizienten an die DBF-Einheit (15), so dass Kalibrierungsergebnisse der jeweiligen Systeme in die Strahlformung der Array-Antenne des Satelliten (3) einfließen.

7.  Kalibrierverfahren nach Anspruch 6, wobei der Kalibrierungskoeffizientenberechnungsschritt die Schritte aufweist:

Empfangen der mehreren Eingangssignale; und
Ausführen einer Kalibrierung basierend auf einem Mittelwert der mehreren Eingangssignale, die innerhalb einer vorgegebenen Zeitdauer erhalten werden.

8.  Kalibrierverfahren nach Anspruch 6 oder 7, ferner mit einem Kennlinienänderungsbestimmungsschritt zum Bestimmen, ob in einem oder in mehreren elektronischen Instrumenten, die innerhalb des Satelliten (3) vorgesehen sind, aufgrund einer Störung eine Änderung der Kennlinien aufgetreten ist oder nicht,
wobei der Kalibrierungskoeffizientenberechnungsschritt den Schritt aufweist:
Berechnen der Gewichtungskoeffizienten nur, wenn innerhalb des Satelliten eine Änderung der Kenngrößen aufgetreten ist, und keine Berechnung der Gewichtungskoeffizienten, wenn innerhalb des Satelliten (3) keine Änderung der Kenngrößen aufgetreten ist.

9.  Kalibrierverfahren nach einem der Ansprüche 6 bis 8, wobei der Kalibrierungskoeffizientenberechnungsschritt aufweist:

einen Korrelationsmatrixberechnungsschritt zum Berechnen einer Korrelationsmatrix der mehreren Eingangssignale;
einen Eigenwertberechnungsschritt zum Berechnen eines maximalen Eigenwerts der im Korrelationsmatrixberechnungsschritt berechneten Korrelationsmatrix;
einen Eigenvektorberechnungsschritt zum Berechnen eines Eigenvektors des maximalen Eigenwerts; und
einen Gewichtungskoeffizientenberechnungsschritt zum Berechnen einer Proportionalitätskonstante derart, dass eine Norm des Eigenvektors den Wert 1 hat, und zum Ausgeben eines Produkts der Proportionalitätskonstante und des Eigenvektors als Gewichtungskoeffizienten.

10. Kalibrierverfahren nach einem der Ansprüche 7 bis 9, wobei der Kalibrierungskoeffizientenberechnungsschritt die Schritte aufweist:

Übertragen der mehreren Eingangssignale vom Satelliten (3) an eine Bodenstation (2, 4); und
Übertragen der durch die Bodenstation (2, 4) berechneten Gewichtungskoeffizienten von der Bodenstation (2, 4) an den Satelliten (3).

**Revendications**

1.  Dispositif d'étalonnage (20A, 20B) configuré de manière à mettre en oeuvre l'étalonnage d'une pluralité de systèmes d'une antenne en réseau montée sur un satellite (3) avec une unité de conformation de faisceau numérique, DBF, (15), ledit satellite (3) étant agencé dans l'espace, le dispositif d'étalonnage (20A, 20B) étant **caractérisé par** :

une unité de calcul de coefficients d'étalonnage (21) configurée de manière à recevoir une pluralité de signaux d'entrée qui sont divisés par des systèmes respectifs et qui sont appliqués en entrée à l'unité de conformation DBF (15) sur le satellite (3), et qui sont obtenus en mettant en oeuvre, dans les systèmes respectifs, un traitement de signal prédéterminé pour des signaux reçus par l'antenne en réseau, à calculer une corrélation de la pluralité des signaux d'entrée, et à calculer des coefficients de pondération pour les systèmes respectifs de l'antenne en réseau au cours d'une communication par satellite à travers l'antenne en réseau ; et
une unité d'exécution d'étalonnage (27) configurée de manière à étalonner les systèmes respectifs de l'antenne en réseau en fournissant en sortie les coefficients de pondération à l'unité de conformation DBF (15), de sorte que des résultats d'étalonnage des systèmes respectifs sont réfléchis vers la conformation de faisceau de l'antenne en réseau du satellite (3).

2. Dispositif d'étalonnage selon la revendication 1, dans lequel l'unité de calcul de coefficient d'étalonnage (21) est configurée de manière à mettre en oeuvre un étalonnage sur la base d'une valeur moyenne de la pluralité de signaux d'entrée obtenue au cours d'une période de temps donnée.

3. Dispositif d'étalonnage (20A, 20B) selon la revendication 1 ou 2, dans lequel l'unité de calcul de coefficient d'étalonnage (21) comprend :

une section de calcul de matrice de corrélation (22) destinée à calculer une matrice de corrélation de la pluralité de signaux d'entrée ;
une section de calcul de valeur propre (23) destinée à calculer une valeur propre maximale de la matrice de corrélation calculée par la section de calcul de matrice de corrélation (22) ;
une section de calcul de vecteur propre (24) destinée à calculer un vecteur propre de la valeur propre maximale ; et
une section de calcul de coefficients de pondération (26) destinée à calculer une constante de proportionnalité de sorte qu'une norme du vecteur propre devient « 1 », et à fournir en sortie un produit de la constante de proportionnalité et du vecteur propre en tant que les coefficients de pondération.

4. Dispositif d'étalonnage (20A, 20B) selon l'une quelconque des revendications 1 à 3, comprenant en outre une section de détermination de modification de caractéristiques (25) configurée de manière à déterminer si une modification de caractéristiques s'est produite ou non dans un ou plusieurs instruments électroniques fournis à l'intérieur du satellite (3), sous l'effet de perturbations ;
dans lequel le dispositif d'étalonnage (20A, 20B) est configuré de manière à calculer les coefficients de pondération uniquement lorsque la modification des caractéristiques s'est produite à l'intérieur du satellite (3), et est configuré de manière à ne pas calculer les coefficients de pondération lorsqu'aucune modification des caractéristiques ne s'est produite à l'intérieur du satellite (3).

5. Dispositif d'étalonnage (20A, 20B) selon l'une quelconque des revendications 1 à 4, dans lequel l'unité de calcul de coefficient d'étalonnage (21) est montée sur une station au sol (2, 4) et est configurée de manière à recevoir la pluralité de signaux d'entrée en provenance du satellite (3), à calculer les coefficients de pondération sur la base de la pluralité de signaux d'entrée, et à transmettre les coefficients de pondération au satellite (3).

6. Procédé d'étalonnage pour étalonner une antenne en réseau d'une pluralité de systèmes montés sur un satellite (3) conjointement avec une unité de conformation de faisceau numérique, DBF, (15), le procédé d'étalonnage comprenant :

une étape de calcul de coefficients d'étalonnage consistant à recevoir une pluralité de signaux d'entrée qui sont divisés par des systèmes respectifs et qui sont appliqués en entrée à l'unité de conformation DBF (15) sur le satellite (3), et qui sont obtenus en mettant en oeuvre, dans les systèmes respectifs, un traitement de signal prédéterminé pour des signaux reçus par l'antenne en réseau, à calculer une corrélation de la pluralité de signaux d'entrée, et à calculer des coefficients de pondération pour les systèmes respectifs de l'antenne en réseau au cours d'une communication par satellite à travers l'antenne en réseau ; et
une étape d'exécution d'étalonnage consistant à étalonner chacun des systèmes respectifs de l'antenne en réseau en fournissant en sortie les coefficients de pondération à l'unité de conformation DBF (15), de sorte que des résultats d'étalonnage des systèmes respectifs peuvent être réfléchis vers la conformation de faisceau de l'antenne en réseau du satellite (3).

7. Procédé d'étalonnage selon la revendication 6, dans lequel l'étape de calcul de coefficients d'étalonnage comprend les étapes ci-dessous consistant à :

recevoir la pluralité des signaux d'entrée ; et
mettre en oeuvre l'étalonnage sur la base d'une valeur moyenne de la pluralité de signaux d'entrée obtenue au cours d'une période de temps donnée.

8. Procédé d'étalonnage selon la revendication 6 ou 7, comprenant en outre une étape de détermination de modification de caractéristiques consistant à déterminer si une modification de caractéristiques s'est produite ou non dans un ou plusieurs instruments électroniques fournis à l'intérieur du satellite (3), sous l'effet de perturbations ;

dans lequel l'étape de calcul de coefficients d'étalonnage consiste à :

calculer les coefficients de pondération uniquement lorsque la modification des caractéristiques s'est produite à l'intérieur du satellite, et ne pas calculer les coefficients de pondération lorsqu'aucune modification des caractéristiques ne s'est produite à l'intérieur du satellite (3).

9. Procédé d'étalonnage selon l'une quelconque des revendications 6 à 8, dans lequel l'étape de calcul de coefficients d'étalonnage comprend :

une étape de calcul de matrice de corrélation consistant à calculer une matrice de corrélation de la pluralité de signaux d'entrée ;

une étape de calcul de valeur propre consistant à calculer une valeur propre maximale de la matrice de corrélation calculée à l'étape de calcul de matrice de corrélation ;

une étape de calcul de vecteur propre consistant à calculer un vecteur propre de la valeur propre maximale ; et

une étape de calcul de coefficients de pondération consistant à calculer une constante de proportionnalité de sorte qu'une norme du vecteur propre devient « 1 », et à fournir en sortie un produit de la constante de proportionnalité et du vecteur propre en tant que les coefficients de pondération.

10. Procédé d'étalonnage selon l'une quelconque des revendications 7 à 9, dans lequel l'étape de calcul de coefficients d'étalonnage comprend les étapes ci-dessous consistant à :

transmettre la pluralité de signaux d'entrée à une station au sol (2, 4) à partir du satellite (3) ; et

transmettre les coefficients de pondération calculés par la station au sol (2, 4) au satellite (3), à partir de la station au sol (2, 4).

FIG. 1

EP 2 602 631 B1

10

G1

11a(11)    11b(11)    11n(11)

12a(12)    12b(12)    12n(12)
LNA        LNA        LNA

13a(13)    13b(13)    13n(13)
DNC        DNC        DNC

14a(14)    14b(14)    14n(14)
ADC        ADC        ADC

· · ·

X1(t)

X2(t)

Xn(t)

15

21

DBF

22
CORRELATION MATRIX
CALCULATING SECTION

23
EIGENVALUE
CALCULATING SECTION

24
EIGENVECTOR
CALCULATING SECTION

25
CHARACTERISTIC
CHANGE DETERMINING
SECTION

26
WEIGHTING COEFFICIENT
CALCULATING SECTION

27
CALIBRATION
EXECUTING UNIT

20A
CALIBRATION DEVICE

FIG. 2

13

START

S1
CALCULATE
CORRELATION MATRIX

S2
CALCULATE EIGENVALUES

S3
CALCULATE EIGENVECTOR

S4
HAVE
CHARACTERISTICS
CHANGED?

N

Y

S5
CALCULATE WEIGHTING
COEFFICIENTS

S6
EXECUTE CALIBRATION

END

FIG. 3

FIG. 4

FIG. 5

EP 2 602 631 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004104751 A
- JP 2004260319 A
- JP 2008216152 A
- KR 100762218 B1
- WO 9800930 A1
- JP 2010173338 A